Europäisches Patentamt

(19) European Patent Office    (11) Publication number: **0 070 101**

Office européen des brevets    **B1**

(12) **EUROPEAN PATENT SPECIFICATION**

(45) Date of publication of patent specification: **21.11.85**    (51) Int. Cl.⁴: **H 01 L 27/08, H 01 L 29/78**

(21) Application number: **82303065.5**

(22) Date of filing: **14.06.82**

(54) **Mos transistors.**

(30) Priority: **06.07.81 US 282103**

(43) Date of publication of application:
**19.01.83 Bulletin 83/03**

(45) Publication of the grant of the patent:
**21.11.85 Bulletin 85/47**

(84) Designated Contracting States:
**DE FR GB IT NL**

(56) References cited:
**US-A-3 793 721**
**US-A-4 058 822**

**PATENTS ABSTRACTS OF JAPAN, vol. 4, no.
104(E-19)(586), 25th July 1980, page 112E19
IEEE JOURNAL OF SOLID-STATE CIRCUITS,
vol. SC-16, no. 3, June 1981, pages 212-226,
New York, USA E.HABEKOTTE et al.: "A
coplanar CMOS power switch"**

(73) Proprietor: **XEROX CORPORATION
Xerox Square - 020
Rochester New York 14644 (US)**

(72) Inventor: **Rumennik, Vladimir
7742 Redlands Street
Playa Del Ray California 90291 (US)**
Inventor: **Heald, David L.
976 Ballard Canyon Road
Solvang California 93463 (US)**

(74) Representative: **Weatherald, Keith Baynes et al
European Patent Attorney Rank Xerox Limited
Patent Department 338 Euston Road
London NW1 3BH (GB)**

Courier Press, Leamington Spa, England.

## Description

This invention relates to a high voltage pinch-off channel metal oxide semiconductor transistor according to the first part of claim 1. Such a transistor is known from Patent Abstracts of Japan, Vol. 4, No. 104 (E-19) 586, 1980, p 112E19.

Complementary metal oxide semiconductor (CMOS) transistor structures are commonly used to switch low voltages at high speed with low power dissipation. Such CMOS transistor structures can be of the pinch-off channel type, being comprised of an n-channel MOS transistor provided by heavily doped, n-type source and drain regions formed in a p-type silicon substrate, and a p-channel MOS transistor provided by heavily doped, n-type source and drain regions formed in an n-type well provided within the substrate by ion implantation or diffusion. For low voltage operation, the substrate is grounded and the well is maintained at a low voltage, generally not exceeding twenty volts.

It would be desirable to have CMOS transistor structures of the pinch-off channel type that could operate at high voltage (50 volts or more). High voltage operation of the n-channel MOS transistors of the conventional pinch-off channel type is generally not a problem because the substrate is lightly doped (for example, $10^{14}$ atoms $cm^{-3}$), which makes high junction breakdown voltages possible. However, high voltage operation of p-channel MOS transistors of the conventional pinch-off channel type is a problem because during circuit operation the drain will sometimes be at a low voltage while the well is biased at a high voltage (above 50 volts), making it necessary for the drain-well junction to support a voltage of a magnitude which may exceed the breakdown voltage of that junction.

It has been suggested (see "A Monolithic 200-V CMOS Analog Switch" by James D. Plummer et al, IEEE Journal of Solid-State Circuits, Vol. SC-11, No. 6, December 11, 1976, and "Lateral DMOS Power Transistor Design" by Colak et al, IEEE Electron Device Letters, Vol. EDL-1 No. 4, April 1980) that high voltage operation of a p-channel MOS transistor can be achieved by fabricating the transistor within a thick expitaxial layer provided at a surface of the substrate. These publications emphasize that the epitaxial layer must be thick (25 µm) to prevent punchthrough breakdown of the depletion regions associated with the drain-well and well-substrate junctions. An epitaxial layer of such thickness must be grown, thereby adding greatly to fabrication costs.

It has been found that a thick, grown epitaxial layer is not a necessary component of a p-channel MOS transistor of the pinch-off channel type required to operate at high voltages. According to the invention as claimed a high voltage operation of a MOS transistor of the pinch-off channel type can be achieved with a shallow substrate well, that is, a well which is no more than five µm deep, whereby depletion regions associated with the reverse-biased drain-well and well-substrate junctions combine at moderate voltage. Such a well can be formed by a diffusion or ion implantation process. With such a shallow well, as the drain voltage is reduced toward zero from the high voltage bias on the well, the depletion region associated with the drain-well junction increases in size and eventually punches through to the depletion region associated with the well-substrate junction. Even after punchthrough there will still be a large potential barrier existing to current flow between the drain and the substrate because both the drain-well and well-substrate junctions are reverse biased. After punchthrough, continued reduction of the voltage on the drain (increasing the drain-well voltage differential) will result in expansion of the combined depletion region in the horizontal or lateral direction. Thus, the combined depletion region creates a broad insulating region which can support a lateral field that can span large horizontal distances and thus support high voltages.

Since the shallow well can be formed by a diffusion or ion implantation process, the fabrication costs of the single layer material transistor are greatly reduced. However, satisfactory operation can be achieved using a thin epitaxial layer with appropriate electrical isolation for electrical separation of adjacent transistors of an array. Obviously, when a diffused well is used, the well-substrate junction provides the appropriate electrical isolation between adjacent transistors of an array.

The present invention will now be described by way of example with reference to the accompanying drawings, in which:

Figures 1 and 1A show top and sectional views of a CMOS structure incorporating the MOS transistor of the present invention;

Figure 1C shows a circuit schematic of a CMOS structure;

Figures 2—4 depict the depletion regions of the MOS transistor of the invention for different applied voltages;

Figure 5 depicts potential barriers to current flow, and

Figures 6—19 show various process steps for making the MOS transistor of the invention.

The pinch-off channel MOS transistor of the invention will be described in the environment of a CMOS structure. However, the MOS transistor can operate as an isolated transistor or in combinations other than CMOS structures.

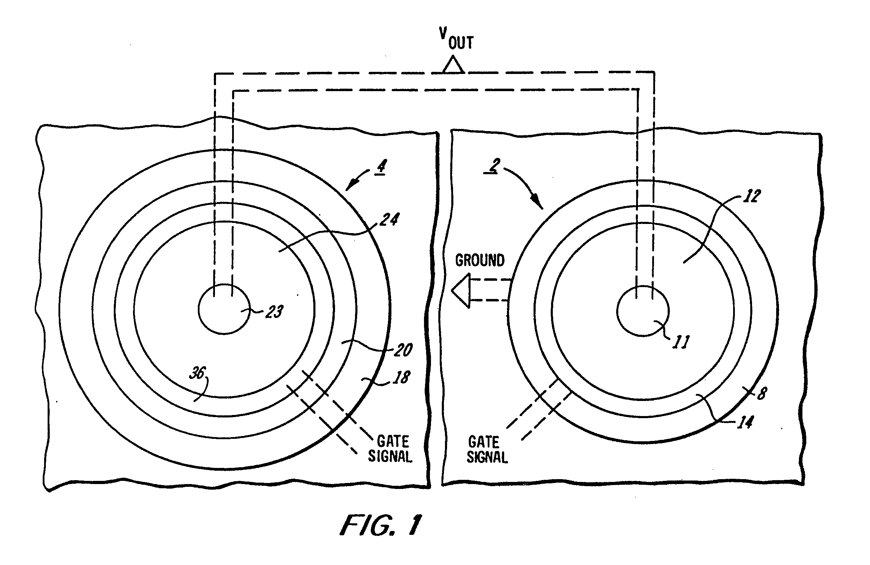

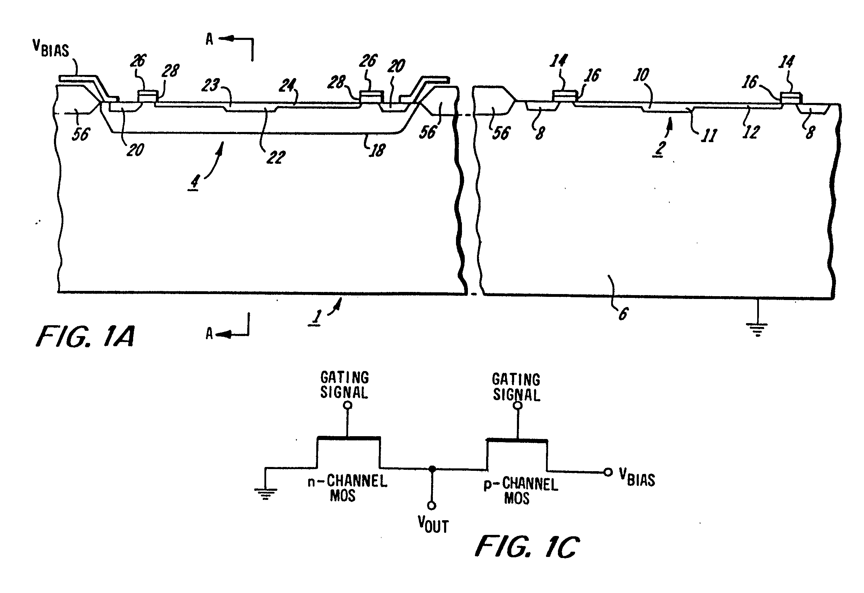

Referring to Figures 1 and 1A, there are shown top and cross-sectional views of a CMOS transistor integrated circuit structure 1 comprised of an n-channel MOS transistor 2 and a p-channel MOS transistor 4 formed in a lightly doped (60 ohm cm) p-type substrate 6. Transistor 2 is of conventional construction, consisting of a heavily doped ($10^{19}$—$10^{20}$ atoms $cm^{-3}$) n-type source region 8, and a drain region 10 comprised of a portion 11 that is heavily doped ($10^{19}$—$10^{20}$ atoms $cm^{-3}$) n-type and a shallower n-type portion 12 that is lightly doped with dose 1—$3\times10^{12}$ atoms $cm^{-3}$. The adjacent portions of source and drain regions 8 and 10 are overlapped by a gate electrode 14 which is separated from the substrate surface by a thin insulating layer 16. For CMOS operation, substrate 6 and region 8 are at a reference potential, generally ground.

Transistor 4 is comprised of an n-type well 18 formed in substrate 6, and source and drain regions 20 and 22, respectively, within well 18. Source region 20 is heavily doped ($10^{19}$—$10^{20}$ atoms cm$^{-3}$) p-type, and drain region 22 is comprised of a portion 23 that is heavily doped ($10^{19}$—$10^{20}$ atoms cm$^{-3}$) p-type and a shallower p-type portion 24 that is lightly doped with dose 1—$3 \times 10^{12}$ atoms cm$^{-3}$. The adjacent portions of source and drain regions 20 and 22 are overlapped by a gate electrode 26 which is separated from the substrate surface by a thin (100 nm) insulating layer 28. As shown by Figure 1, both MOS transistors 2 and 4 have a concentric configuration with their respective drains as their centers.

For CMOS operation, source region 20 and well 18 are maintained at V bias, which, for high voltage operation would be in excess of fifty (50) volts, and drain regions 10 and 22 are electrically connected to provide an output voltage V out. For other applications drain regions 10 and 22 need not be electrically connected. Control or gating signals are supplied to gate electrodes 14 and 26. An electrical schematic of CMOS integrated circuit structure 1 is shown in Figure 1C.

The CMOS transistor integrated circuit structure of Figure 1 has considerable advantages in regards to circuit performance requirements such as gain and linearity. Difficulties with CMOS transistor structures arise, however, when they are forced to operate in a high voltage environment. As noted, for normal high voltage operation, the substrate 6 is grounded and the well 18 is at a high voltage, over fifty (50) volts, making it necessary for the reverse biased well-substrate junction to support a large voltage differential. In addition, in circuit operation the drain 22 will at times be at a relatively low voltage with respect to the well voltage, making it necessary for the reverse biased drain-well junction to support also a relatively large voltage. The large voltage differential across the reverse biased drain-well junction will produce a depletion region along the drain-well junction, and likewise, the large voltage differential across the reverse biased well-substrate junction will produce a depletion region along the drain-well junction. The conventional teaching is that high voltage operation can be achieved if the depletion regions are kept separate, that is no punchthrough or merging of the depletion regions. Prevention of punchthrough would be prevented, in accordance with the conventional teaching of Plummer *et al*, by making the well 18 deep (25 μm or more) and highly resistive, such as by forming MOS transistor 4 within a thick, epitaxial layer or well.

The pinch-off channel MOS transistor 4 disclosed herein utilizes a well 18 that is very shallow compared to the depth of the well in conventional structures. Specifically, well 18 has a depth that will permit the depletion regions associated with the reverse-biased drain-well and well-substrate junction to punchthrough or merge at times when the drain-well voltage differential is moderately high. More specifically, when the maximum depth of the source and drain regions 20 and 22 is about one μm well 18 has a depth of approximately four—five μm. Also, well 18 is more heavily doped than substrate 6, having a doping dose of about $10^{16}$ atoms cm$^{-3}$.

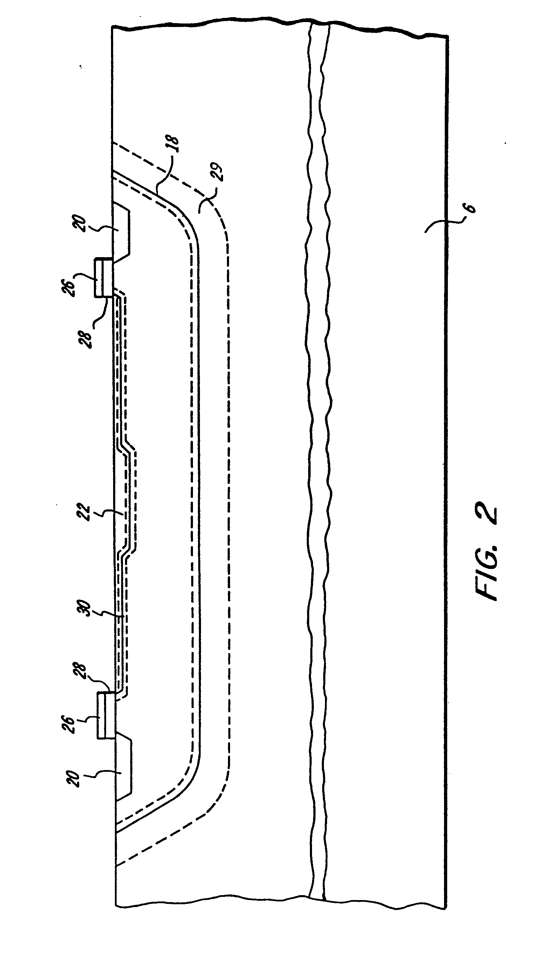

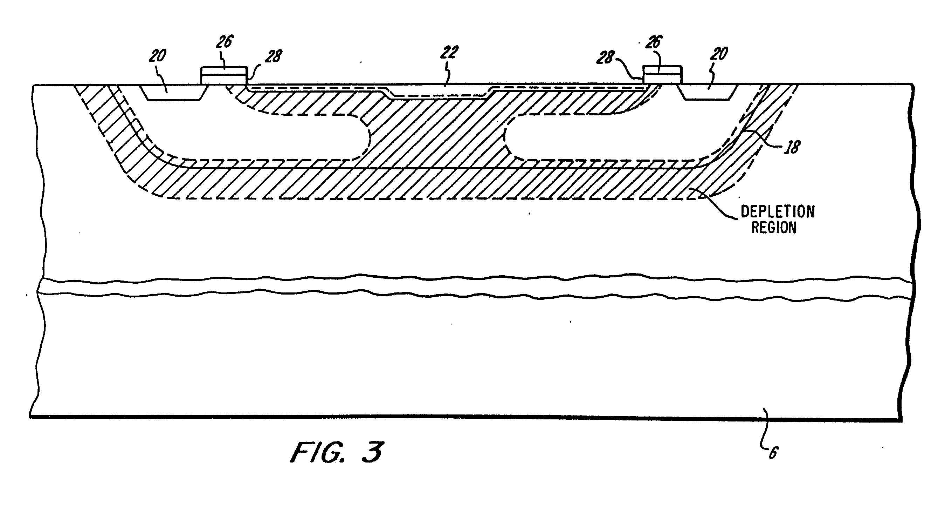

The manner in which the p-channel MOS device 4 can operate at high voltages with a shallow well 18 is explained in relation to Figures 2—4. Because of the large voltage differential across the well-substrate junction, a relatively wide depletion region 29 is associated with that junction (Figure 2). When drain 22 is at a high voltage, a small voltage differential exists across the drain-well junction causing the depletion region 30 associated with that reverse biased junction to be relatively narrow, that is, depletion region 30 extends only slightly to both sides of the drain-well junction (Figure 2). As the voltage on drain 22 decreases, the voltage differential across the drain-well junction increases, and, as a result, the depletion region 30 will increase in size and, with continued decrease of the drain voltage, the depletion region 30 eventually meets or punches through the depletion region 29 associated with the well-substrate junction, forming a combined depletion region as shown by the hatched area in Figure 3. No current flow results, however, between the drain and the substrate because both the drain-well and the well-substrate junctions are reverse biased.

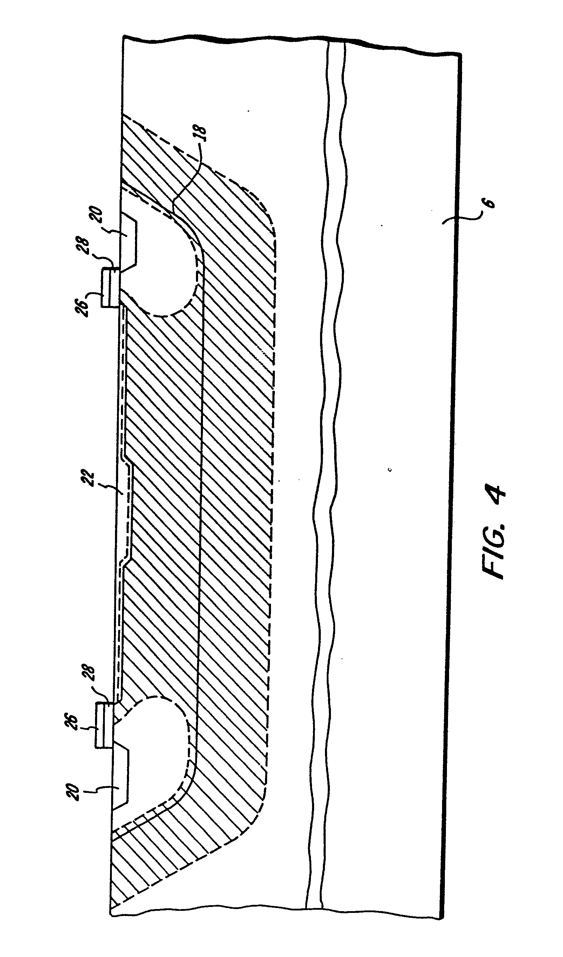

After the depletion regions 29 and 30 punchthrough or overlap in the vertical direction, continued reduction of the voltage on drain 22 (increasing the voltage differential between drain 22 and well 18) will expand the combined depletion region in the horizontal direction, as shown by the hatched area in Figure 4. Thus, merging of the depletion regions creates an insulating region having a large lateral (horizontal) expanse which can support a lateral field spanning large distances, and thus the shallow well pinch-off channel MOS transistor 4 can support large voltages.

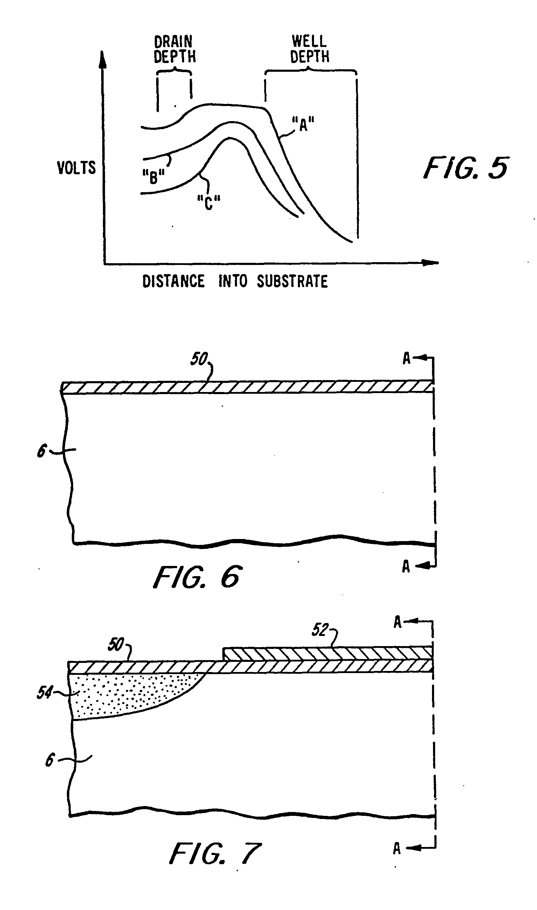

Figure 5 depicts the potential barrier to current flow for various voltages on drain 22 as a function of distance from the drain to the substrate. Curve "A" of Figure 5 depicts the potential barrier when the drain 22 is at a relatively high voltage, that is, prior to punchthrough of the depletion regions 29 and 30. At punchthrough (curve "B" of Figure 5), the potential barrier to current flow is increased, and beyond punchthrough, that is, still lower voltages on drain 22, the potential barrier to current flow (curve "C" of Figure 5) is increased still further. Thus, even though there is punchthrough of the depletion regions 29 and 30, there is a large and increased potential barrier to current flow between the drain 22 and the substrate 6. Breakdown will not occur if the maximum field across the drain-substrate is kept below the critical limit.

As noted, drain 22 is comprised of a shallow portion 24 that is lightly doped and a deeper portion 23 that is heavily doped. The light doping of drain portion 24 permits that portion to be depleted easily of carriers as the drain voltage decreases (because of increasing conduction of n-channel MOS device 2), thereby effecting pinch-off of drain portion 24. When it is desired that p-channel device 4 conducts, the bias applied to gate 26 is decreased, creating, in a conventional manner, an inversion layer adjacent gate 26 so as to promote conduction between source 20 and drain 22.

As noted, well 18 can have a depth of approximately four—five µm. With such a well depth, other dimensional parameters of the pinch-off channel MOS device 4 would be: source 20—lateral dimension approximately ten µm and depth approximately one µm, drain portion 24—depth approximately one-half µm and lateral dimension outward from portion 23 approximately 40 µm when the maximum drain-well voltage differential is to be about 400 volts, that is, one µm per voltage differential of ten, drain portion 23—lateral dimension approximately 20 µm and depth approximately one µm, lateral dimension of well 18 about three hundred (300) µm, and lateral spatial dimension between source 20 and drain portion 24 approximately five—ten µm. N-channel MOS device 2 would have conventional dimensions.

It will be appreciated that the dimensions set forth for MOS device 4 are exemplary and can be varied depending on voltage handling requirement, but, in all cases the well 18 would be shallow (approximately four—five µm). It will also be appreciated that the well 18 can be p-type, in which case substrate 6, drain 22 and source 20 would be n-type, with biasing and gating voltages being of the appropriate polarity.

In the controllable process for fabricating the high voltage complementary metal oxide semiconductor field effect transistor (HVCMOSFET) 4, there are 14 major process steps. The major process steps are described in relation to Figures 6 through 19. For simplicity, Figures 6—19 show formation of only the portion of transistor 4 to the left of central axis A—A of Figure 1A, but it is clearly apparent that the other portion of transistor 4 would be formed simultaneously using masks that are the mirror image of those shown.

The first major process step for the HVCMOSFET structure is shown in Figure 6 and is known as the substrate oxidation step. In particular, as a first substep in this process step, in the p-channel mode, a silicon substrate 6 is relatively lightly doped to be p minus. As a second substep in this process step, the p minus substrate 6 is thermally oxidized to provide an oxide or silicon dioxide layer 50 having a predetermined depth of approximately 40 nm.

The second major process step for the HVCMOSFET structure is shown in Figure 7 and is known as the field implant step. In particular, as a first substep in this process step, a field implant or photoresist mask 52 is formed on the layer 50 using photolithographic techniques. As a second substep in this process step, a field implant or ion implant with a predetermined amount of p doping, such as boron, is applied where the field implant mask 52 does not impede it to form p area 54 as a field inversion stopper.

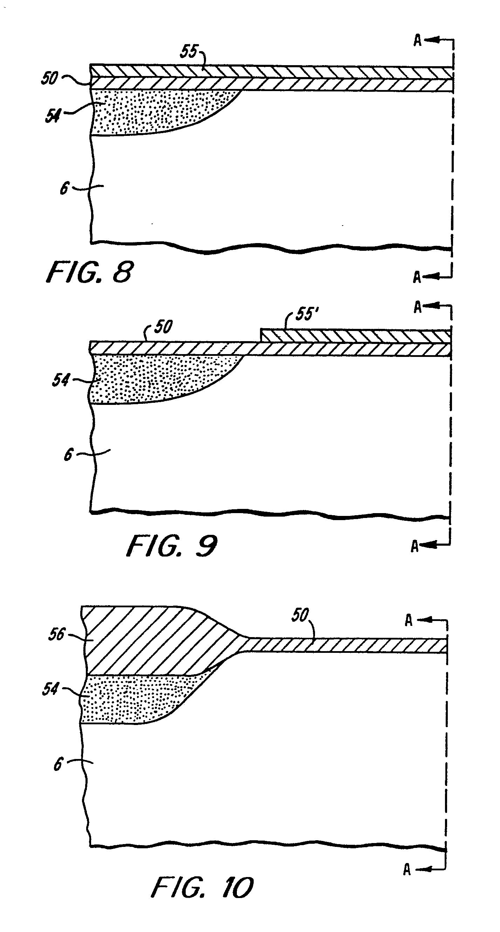

The third major process step for the HVCMOSFET structure is shown in Figure 8 and is known as the silicon nitride deposition step. In particular, silicon nitride is deposited or grown as a layer 55 over the silicon dioxide layer 50 (with mask 52 removed) to a predetermined thickness of approximately 100 nm.

The fourth major process step for the HVCMOSFET structure is shown in Figure 9 and is known as the field mask step. In particular, a field mask 55' is formed from the layer 55 using photolithographic mask and etch techniques so as to be disposed between the field inversion stoppers 54. The length of the field mask 55' will determine the lateral span of the well to be formed and in this embodiment will be the approximate predetermined length of about three hundred (300) microns.

The fifth major process step for the HVCMOSFET structure is shown in Figure 10 and is known as the field oxide formatiom step. In particular, as a first substep in this process step, field oxide 56 is thermally grown on the side of and proximate to the field mask 55' to a predetermined thickness of approximately 1 µm for use as an insulation buffer in regards to adjacent formed devices on the substrate 6. As a second substep in this process step, the field mask 55' is removed or etched away down to the level of the layer 50. It will be appreciated that the p area 54 is left with a predetermined depth of approximately two µm.

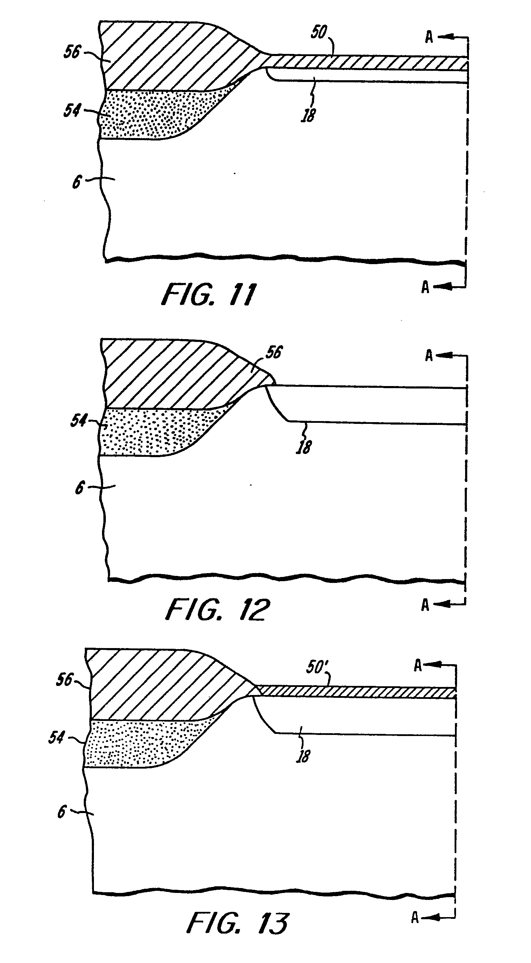

The sixth major process step for the HVCMOSFET structure is shown in Figure 11 and is known as the well implant step. In particular a well implant is made at a predetermined n doping level through the layer 50 in the area not covered by the field oxide 56 which act as barriers to the implant to form an n-doped well area 18 in the substrate 6. Preferably, the entire well 18 has a predetermined depth of approximately one µm and a lateral dimension of about three hundred (300) µm.

The seventh major process step for the HVCMOSFET structure is shown in Figure 12 and is known as the well drive step. In particular, as a first substep in this process step, a well drive is made through thermal diffusion for a predetermined time and heat intensity that is operative to drive down the effective vertical dimension of well 18 to a depth of approximately four—five µm while increasing its lateral dimension by three—four µm. As a second substep, layer 50 is removed or etched away down to the surface of the substrate 6. It will be appreciated that the outer boundary of the n-doped well 18 is the well-substrate junction.

The eighth major process step for the HVCMOSFET structure is shown in Figure 13 and is known as the gate oxidation step. In particular, a new layer 50' of silicon dioxide is formed by thermal growth on the outer surface of the well 18 to a predetermined depth of approximately 100 nm to serve thereafter as the basis for the gate oxide to be described hereafter.

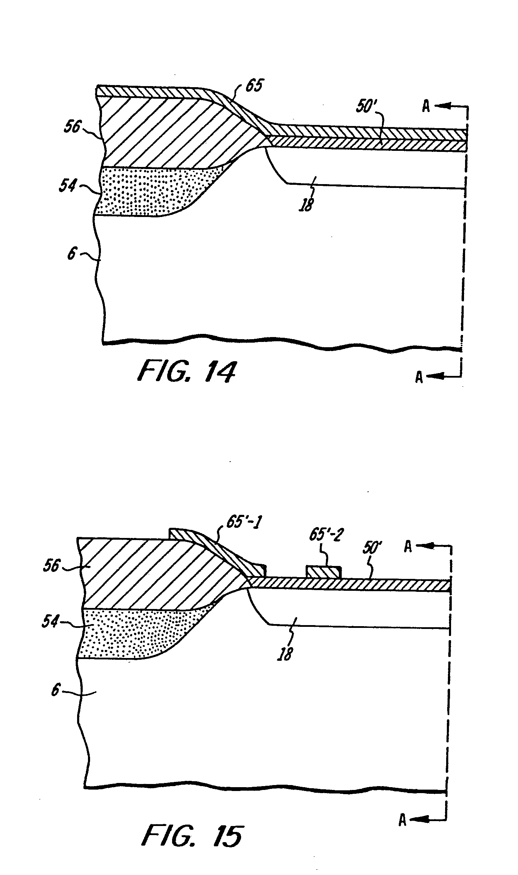

The ninth major process step for the HVCMOSFET structure is shown in Figure 14 and is known as the polysilicon deposition step. In particular, as a first substep in this process step, a layer 65 of polysilicon is grown or deposited over the entire top surface of the HVCMOSFET structure to a predetermined depth of approximately three μm. As a second substep in this process step, n doping with phosphorous is introduced by implanting into the layer 65 at a predetermined concentration.

The tenth major process step for the HVCMOSFET structure is shown in Figure 15 and is known as the polysilicon definition mask step. In particular, islands 65' of polysilicon are formed in the polysilicon layer 65 using photolithographic mask and etch techniques. Islands 65' are spatially offset one as to the other at predetermined distances because of the self-aligning inherent in the mask used in the photolithographic process mentioned above. It will be appreciated that island 65'-1 is disposed predominantly on the surfaces of layer 56 and only relatively small predetermined portions thereof are disposed on the adjacent layer 50'.

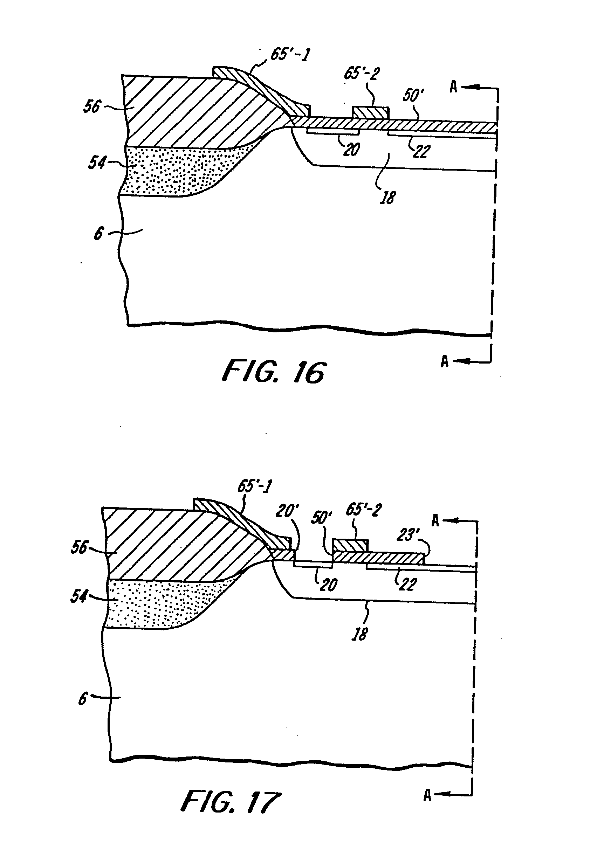

The eleventh major process step for the HVCMOSFET structure is shown in Figure 16 and is known as the MOS pinch-off channel implant step. In particular, a p-type implant at a predetermined concentration is made into the surface of the HVCMOSFET structure except for those areas insulated by the field oxide 56 and islands 65' to a predetermined depth of approxi-mately a half μm to define p-doped areas 20 and 22 partially. The predetermined lateral dimensions are approximately ten to 60 μm for areas 20 and 22, respectively. It will be appreciated that the implant extends a predetermined spatial distance to be slightly under the respective adjacent polysilicon islands 65'.

The twelfth major process step for the HVCMOSFET structure is shown in Figure 17 and is known as the masking for P$^+$ source and drain. In particular, windows 20' and 23' are formed in the layer 50' over the source 20 and the drain portion 23, respectively, using photolithographic mask and etch techniques. Window 20' is about ten μm wide and window 23' is about 20 μm wide. It will be appreciated that the oxide under island 65'-2 is the gate oxide 28. Next, boron implants are made through the windows to provide P$^+$ source 20 and P$^+$ drain region 23.

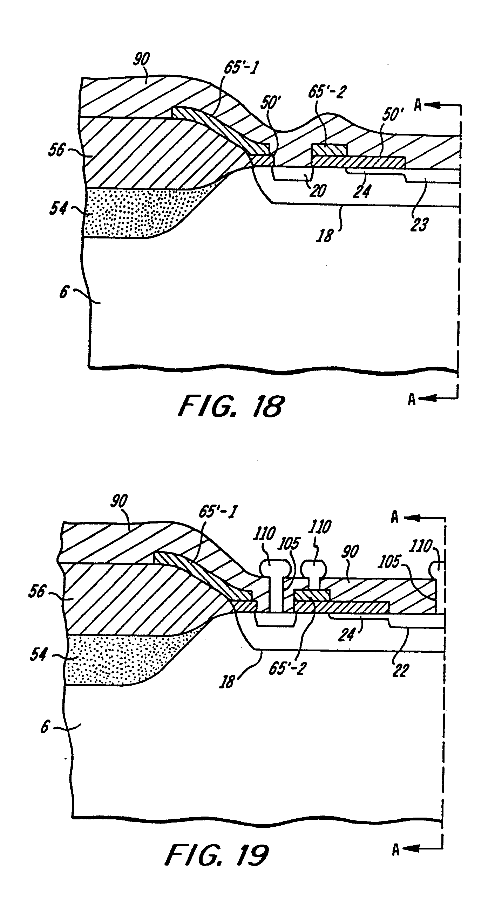

The thirteenth major process step for the HVCMOSFET structure is shown in Figure 18 and is known as the low pressure chemical vapor deposition (LPCVD) step. In particular phosphorous-doped silicon dioxide (PVX) is formed as a layer 90 over the entire surface of the HVCMOSFET structure to a predetermined thickness of approximately one—two μm, followed by heating at approximately 1,000 degrees C. It is noted that formation of layer 90 does not affect the exposed surfaces of the substrate.

As a result of heat-induced diffusion, source 20 and drain portion 23 are driven into the well an additional one-half μm, and the source and drain areas extend out on either side under the layer 50' a predetermined distance of approximately a half μm. It will be appreciated that the extension under the adjacent gate oxide edge is required to create an environment for an inversion layer for the MOS channel below the gate oxide 28 and in addition as a means of self-aligning the source area with respect to the gate oxide. It will be further appreciated that the pinch-off channel or p doped drain portion 24 and the drain portion 23 together form the drain 22 whose outer boundary is the drain-well junction.

The fourteenth and final major process step for the HVCMOSFET structure is shown in Figure 19 and is known as the contact terminal step. In particular, windows 105 are formed in the PVX layer 90 for source, gate and drain terminals or electrodes using photolithographic mask and etch techniques. Next, metal terminals or electrodes 110 for the source drain, and gate electrodes are formed using photolithographic mask and etch techniques, thereby providing terminals for the p-channel MOS transistor 4.

## Claims

1. A high voltage pinch-off channel metal oxide semiconductor transistor (1) formed in single layer material comprising:

a substrate (6) of semiconductor material of a first conductivity type,

a well (18) of the other conductivity type formed within the substrate and extending from a surface of the substrate,

a source region (20) of the first conductivity type formed within the well and extending from the surface,

a drain region (22) of the first conductivity type formed within the well and extending from the surface, and

gating means (26) between the source region and said drain region, characterised in that the well is no more than five μm deep, so that depletion regions associated with the reverse-biased drain-well and well-substrate junctions combine at moderate voltages.

2. The MOS transistor of claim 1, wherein the source region circumscribes the drain region.

3. A transistor as claimed in claim 1 or 2, in combination with a channel MOS transistor (2) of the opposite type, in which both transistors share the same substrate (6); in which the transistor of the opposite type has no well, and in which the drain regions (10, 22) of the two transistors are electrically connected together.

## Patentansprüche

1. Metalloxyd-Halbleitertransistor (1) mit Pinch-off Kanal und für hohe Spannung, der aus einer einzigen Materialschicht gebildet ist, umfassend:
ein Substrat (6) eines Halbleitermaterials einer ersten Leitungsart,
eine Senke (18) der anderen Leitungsart, die in dem Substrat ausgebildet ist und sich von einer Oberfläche des Substrats her erstreckt,
einen Source-Bereich (20) der ersten Leitungsart, der in der Senke gebildet ist und sich von der Oberfläche erstreckt,
ein Drain-Bereich (22) der ersten Leitungsart, die in der Senke gebildet ist und sich von der Oberfläche erstreckt, und
eine Toreinrichtung (26) zwischen dem Source-Bereich und dem Drain-Bereich, dadurch gekennzeichnet, daß die Senke nicht mehr als 5 μm tief ist, so daß sich Verarmungsbereiche, die den in Sperrichtung betriebenen Drain-Senke- und Senke-Substrat-Übergangszonen zugeordnet sind, bei mäßigen Spannungen kombinieren.

2. MOS-Transistor nach Anspruch 1, bei dem der Source-Bereich den Drain-Bereich umgibt.

3. Transistor nach Anspruch 1 oder 2, in Kombination mit einem Kanal-MOS-Transistor (2) entgegengesetzter Art, wobei beide Transistoren das gleich Substrat (6) miteinander teilen, der Transistor der entgegengesetzten Art keine Senke aufweist und die Drain-Bereiche (10, 22) der zwei Transistoren elektrisch miteinander verbunden sind.

## Revendications

1. Transistor (1) en semi-conducteur métal-oxyde à canal de pincement à haute tension, formé dans un matériau en une couche, comprenant:

— un substrat (6) de matériau semi-conducteur ayant un premier type de conductibilité;
— un puits (18) de l'autre type de conductibilité formé à l'intérieur du substrat et s'étendant à partir d'une surface du substrat;
— une région de source (20) du premier type de conductibilité formée à l'intérieur du puits et s'étendant à partir de la surface;
— une région de drain (22) du premier type de conductibilité formée à l'intérieur du puits et d'étendant à partir de la surface; et
— un moyen de contrôle (26) entre la région de source et la région de drain, caractérisé en ce que le puits n'a pas plus de 5 μm deprofondeur, de sorte que les régions d'épuisement associées aux jonctions puits-substrat et puits-drain à polarisation inverse se combinent à des tensions modérées.

2. Transistor MOS selon la revendication 1, où la région de source circonscrit la région de drain.

3. Transistor selon la revendication 1 ou la revendication 2, en combinaison avec une transistor MOS à canal (2) du type opposé, dans lequel les deux transistors partagent le même substrat (6); dans lequel le transistor du type opposé ne comporte par de puits, et dans lequel le régions de drain (10, 22) des deux transistors sont connectés électríquement.

FIG. 1

FIG. 1A

FIG. 1C

0 070 101

*FIG. 2*

0 070 101

FIG. 3

DEPLETION REGION

FIG. 4

FIG. 5

FIG. 6

FIG. 7

6

FIG. 8

FIG. 9

FIG. 10

FIG. 11

FIG. 12

FIG. 13

FIG. 14

FIG. 15

**FIG. 16**

**FIG. 17**

FIG. 18

FIG. 19